# EUROPEAN PATENT APPLICATION

(11) **EP 0 976 497 A2**
(43) Date of publication of application: **02.02.2000**
(21) Application number: 99112008.0
(22) Date of filing: 21.06.1999
(51) Int. Cl.: B24B 37/04, B24B 55/00, B08B 3/00

(54) **Cleaning apparatus**

(30) Priority: 30.06.1998 JP 18440598
(71) Applicant: Speedfam Co., Ltd., Kanagawa 252-1123 (JP)
(72) Inventor: Hatano, Kazutomo, Ayase-shi, Kanagawa (JP)
(74) Representative: Kehl, Günther, Dipl.-Phys.

(57) **Abstract**

In a polishing apparatus, a hollow member composed of a barrier membrane in which a fluid is sealed is interposed between a mount plate having a workpiece fixed to the lower surface of it and a mount head located above the mount plate. The portion of the hollow member, through which the mount plate is pressed, is formed to have a flat surface so that the hollow member can approximately uniformly press the mount plate. With this arrangement, the surface of a workpiece such as a silicon wafer and the like can be uniformly polished by the polishing apparatus.

## Description

### BACKGROUND OF THE INVENTION

### 1. Field of the Invention

The present invention relates to a polishing apparatus for polishing the surface of a workpiece such as a silicon wafer and so forth.

### 2. Description of the Related Art

In general, silicon wafers have been used as a substrate material for semiconductors such as ICs, LSIs and the like. One of the surfaces of the silicon wafer is mirror-polished.

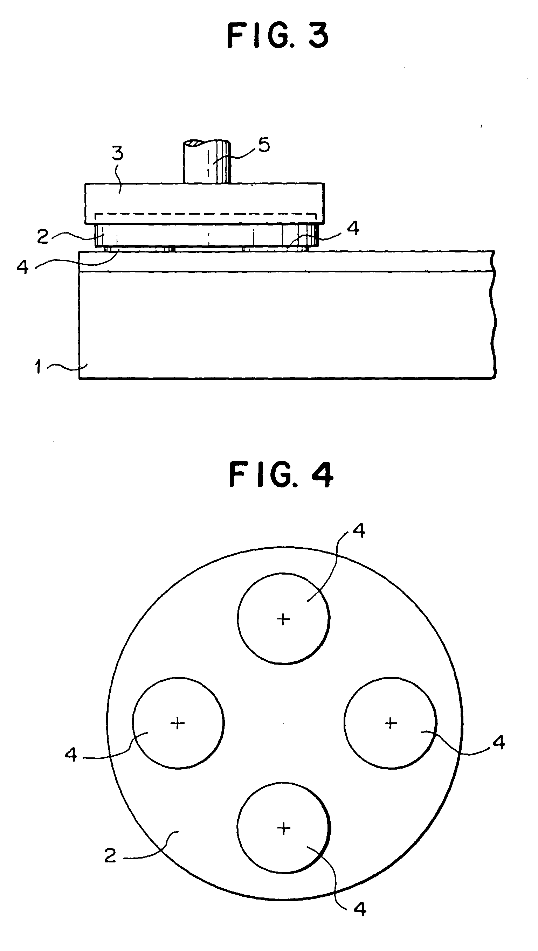

There is conventionally known a silicon wafer polishing apparatus as shown in FIG. 3 as a polishing apparatus for polishing the silicon wafer.

In FIG. 3, numeral 1 denotes a surface plate, numeral 2 denotes a mount plate, numeral 3 denotes a mount head mounted on the upper portion of the mount plate 2.

The surface plate 1 has an abrasive pad attached to the upper surface thereof and is arranged as a circular rotary plate when viewed from an upper side.

The mount plate 2 is a disc composed of ceramics or a glass material and both the sides of it is polished to a flat surface. As shown in FIG. 4, one or a plurality (4 in FIG. 4) of silicon wafers 4 ... are fixed to one of the surfaces of the mount plate 2 at equal intervals when viewed from an upper side.

As a method of fixing the silicon wafers 4 to the mount plate 2, there are exemplified a wax method, in which one of the surfaces of each silicon wafer 4 is coated with wax and each silicon wafer 4 is bonded to the surface of the mount plate 2, and a waxless method, in which each silicon wafer 4 is fixed to the surface of the mount plate 2 by being bonded thereto through vacuum adsorption, water adhesion, or the like.

The mount plate 2, which has the silicon wafers 4 fixed to the surface thereof by the above methods, is placed on the upper surface of the surface plate 1 with the surface thereof, to which the silicon wafers 4 are fixed, facing downward.

One or a plurality of the mount plates 2 are placed on the upper surface of one surface plate 1 (only one of them is shown in the figure). These mount plates 2 ... are disposed in a peripheral direction at equal intervals when viewed from an upper side. Each of the mount plates 2 ... is engaged with the mount head 3 at the upper portion thereof and the upper surface of each of them is in intimate contact with the inner flat surface of the mount head 3.

The mount head 3 has a pressurizing shaft 5 connected to the upper central portion thereof and is arranged to carry out a head-shaking motion and a rotational motion with respect to the pressurizing shaft 5.

When the silicon wafers 4 are to be polished by means of the polishing apparatus arranged as described above, first, abrasive grain such as an alkaline suspension of colloidal silica, or the like is dispersed on the upper surface of the surface plate 1.

The mount plate 2, to which the silicon wafers 4 are fixed, is placed on the upper surface of the surface plate 1 prepared as described above in the state that the surface of the mount plate 2, to which the silicon wafers 4 are fixed, faces downward. Then, the mount head 3 disposed above the mount plate 2 is fitted to the upper portion of the mount plate 2.

Thereafter, the silicon wafers 4 are pressed against the upper surface of the surface plate 1 by pressing the pressurizing shaft 5, which is connected to the upper portion of the mount head 3, using an air cylinder, a hydraulic cylinder or the like (dead weight method is also available).

The surface plate 1 is rotated in this state. At the time, when a silicon wafer 4 is in contact with the surface plate 1 on the outer side of it, the relative speed on the surface where the silicon wafer 4 is in contact with the surface plate 1 is made larger. Thus, among the silicon wafers 4 ... which are fixed to the same mount plate 2, the silicon wafer, which comes into contact with the surface plate 1 on the outer side thereof, is pulled by the surface plate 1 in rotation, whereby the mount plate 2 is rotated in the same direction as the rotational direction of the surface plate 1 together with the mount head 3 fitted to the upper portion of it.

With the above operation, the lower surfaces of the silicon wafers 4 are polished with the abrasive grain dispersed on the upper surface of the surface plate 1.

However, when the silicon wafers 4 are to be polished with the above polishing apparatus, the polishing resistance on the lower surfaces of the silicon wafers 4 is increased on the sides of the silicon wafers 4 to which the rotation of the surface plate 1 is transmitted. Therefore, the lower surfaces of the silicon wafers 4 fixed to the lower surface of the mount plate 2 are inclined outwardly from the center of rotation of the mount plate 2.

The mount plate 2 in this state is forwardly inclined, together with the mount head 3, toward the side of the surface plate 1, from which the rotation of the surface plate 1 is transmitted to the mount plate 2, on the coupling portion at which the mount head 3 is coupled with the pressurizing shaft 5 and which acts as a fulcrum. When this state is achieved, the pressure applied to the lower surfaces of the silicon wafers 4 is distributed such that it is maximized on the sides of the silicon wafers 4 to which the rotation of the surface plate 1 is transmitted, whereby the lower surfaces of the silicon wafers 4 are further inclined. Accordingly, the thicknesses of the respective portions of the silicon wafers 4, which have been polished as described above, are not made uniform.

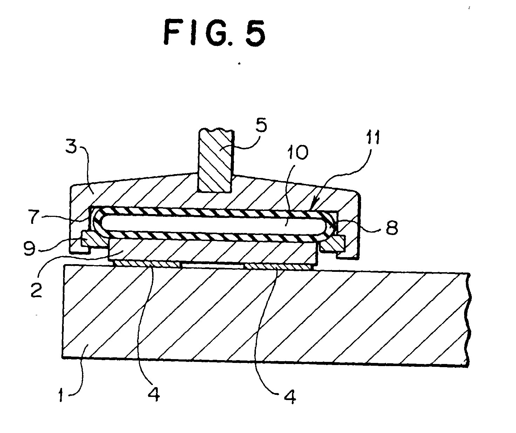

To cope with the above problem, there exists a polishing apparatus as shown in FIG. 5.

The polishing apparatus is arranged such that a mount plate 2 is pressed downward by means of a hollow member 11 in which a fluid 10 is sealed by a barrier membrane 8. More specifically, in the polishing apparatus, the disc-shaped hollow member 11, in which the fluid 10 is sealed by the barrier membrane 8, is interposed between the mount plate 2 and a mount head 3, and the mount head 3 is fixed to a cylindrical pressurizing shaft 5.

The hollow member 11 is fixed to the recess 7 of the mount head 3 by a retainer 9 with the upper surface of it in intimate contact with the inner flat surface of the recess 7. The hollow member 11 itself is composed of the barrier membrane 8 which is formed of an elastic material.

When silicon wafers 4 are to be polished with the polishing apparatus, first, the pressurizing shaft 5 is pressed downward. With this operation, the flat surface inside the mount head 3 presses the fluid 10 in the hollow member 11 through the barrier membrane 8. As a result, the fluid 10 is pressurized to thereby press the upper surface of the mount plate 2 through the barrier membrane 8.

According to the polishing apparatus, the hollow member 11, which is composed of the barrier membrane 8 and the inside of which is filled with the fluid 10, is fitted to the lower portion of the mount head 3; the outer periphery of the barrier membrane 8 is fixed to the mount head 3 by the ring-shaped retainer 9; the barrier membrane 8 is caused to come into intimate contact with the upper surface of the mount plate 2; and the upper surface of the mount plate 2 is pressed by pressure of the fluid 10. However, since the barrier membrane 8 does not uniformly press the upper surface of the mount plate 2, when the silicon wafers 4 are polished with the polishing apparatus, there is a problem that the silicon wafers 4 cannot be uniformly polished.

That is, when the inside of the barrier membrane 8, which constitutes the hollow member 11, is filled with air, the barrier membrane 8 ordinarily expands like a balloon because the barrier membrane 8 itself is formed to have an approximately constant thickness. Thus, the upper surface of the mount plate 2 is not uniformly pressed by the barrier membrane 8.

### SUMMARY OF THE INVENTION

An object of the present invention is to provide a polishing apparatus capable of pressing the entire surface of a silicon wafer with an approximately constant force by causing a hollow member, which is filled with air in the inside thereof, to apply an approximately constant pressing force to the entire surface of a mount plate.

Another object of the present invention is to provide a polishing apparatus capable of adjusting a force for pressing the silicon wafer by adjusting the pressing force applied to the amount plate.

To achieve the above objects, the present invention employs a polishing apparatus for polishing the lower surface of a workpiece in the state that a mount plate having the workpiece fixed to the lower surface thereof is pressed against a surface plate located under the mount plate by a mount head disposed above the mount plate, the polishing apparatus comprising a hollow member disposed in the mount head, the hollow member having a fluid sealed therein and a cross section in which a wall thickness is formed larger on the lower side thereof, wherein the hollow member approximately uniformly presses the mount plate through the portion thereof which is in contact with the mount plate.

Further, a press plate for pressing the hollow member and an adjustment member are disposed in the mount head, the adjustment member can be displaced with respect to the press plate, and the hollow member is adjusted by the adjustment member so that the mount plate can be approximately uniformly pressed by the entire surface of the hollow member which is in contact with the mount plate.

The adjustment member can be adjusted by air pressure.

Furthermore, the present invention employs a polishing apparatus for polishing the lower surface of a workpiece in the state that a mount plate having the workpiece fixed to the lower surface thereof is pressed against a surface plate located under the mount plate by a mount head disposed above the mount plate, the polishing apparatus comprising a hollow member disposed in the mount head, the hollow member having a fluid sealed therein and a cross section in which a wall thickness is formed larger on the lower side thereof; a press plate and an adjustment member disposed in the mount head, the press plate being abutted against the hollow member; and a spring member for pressing the press plate, wherein the hollow member is pressed by the press plate so as to press the mount plate in a prescribed pressed state, the adjustment member is adjusted so that the portion of the hollow member, which is abutted against the mount plate, presses the mount plate approximately uniformly, and the press force is changed by the spring member while the mount plate is uniformly pressed.

The adjustment member can be adjusted by air pressure.

In the present invention, since the mount plate for pressing a silicon wafer is uniformly pressed by the hollow member with the arrangements as described above, the silicon wafer is uniformly pressed. In addition, since the hollow member can be partly pressed by the adjustment member, the adjustment member permits the respective portions of the hollow member to uniformly press the mount plate, whereby an approximately uniform press force can be applied to the respective portions of the silicon wafer. Further, when the pressure in the hollow member is changed due to aged deterioration, an optimum press force can be applied in the state that a uniform press force is maintained to the silicon wafer by pressing the entire hollow member by the press plate.

### BRIEF DESCRIPTION OF THE DRAWINGS

FIG. 1 is a schematic sectional view showing the entire arrangement of a polishing apparatus according to the present invention;
FIG. 2 is a schematic sectional view showing a hollow member used in the polishing apparatus shown in FIG. 1;
FIG. 3 is a schematic sectional view showing the entire arrangement of a conventional polishing apparatus;
FIG. 4 is a schematic view showing the relationship between the mount plate of the polishing apparatus shown in FIG. 3 and silicon wafers; and
FIG. 5 is a schematic sectional view showing the entire arrangement of another conventional polishing apparatus.

### DESCRIPTION OF THE PREFERRED EMBODIMENT

An embodiment of the present invention shown in the drawings will be described below.

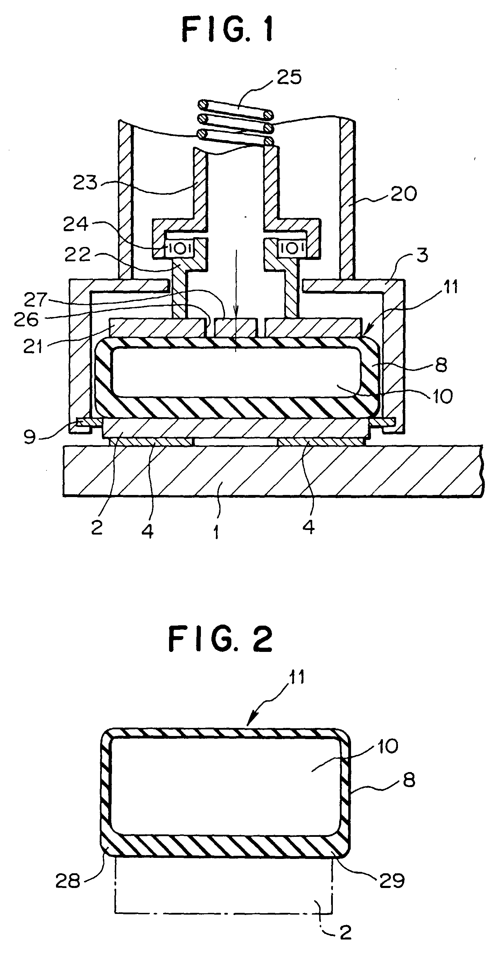

An embodiment of a polishing apparatus of the present invention is shown in FIG. 1, wherein numerals 1 and 2 denote a surface plate and a mount plate, respectively which are similar to those used in the conventional polishing apparatus.

The mount plate 2 is placed on the upper surface of the surface plate 1 in the state that silicon wafers 4 are fixed to the lower surface of it. A hollow shaft member 20 is disposed above the mount plate 2, and a mount head 3, which has an open lower surface, is mounted on the hollow shaft member 20 continuously to the lower end thereof.

A hollow member 11, which is composed of an elastic barrier membrane 8 and in which a fluid 10 is sealed, is located in the mount head 3 as well as a press plate 21 is disposed to the upper surface of the hollow member 11. Whereas, a retainer 9 is disposed to the open edge of the mount head 3 and the mount plate 2 is attached to the retainer 9.

A second hollow support member 22 is disposed to the upper surface of the press plate 21 so as to pass through the upper portion of the mount head 3. Whereas, a first support member 23, which extends into the shaft member 20 from an upper side, is rotatably coupled with the second support member 22 through a bearing 24.

At the time, the first support member 23 is coupled with the second support member 22 through the bearing 24 in the state that the upper end of it is elastically pressed downward by a spring member 25.

Therefore, the second support member 22 can be elastically displaced upward and downward together with the first support member 23 as well as rotated with respect to the first support member 23.

In contrast, in the hollow member 11 in which air is sealed, the thickness of the barrier membrane 8 is not uniform. More specifically, the thickness of the barrier membrane 8 is larger on the upper side of it than the lower side thereof, that is, the barrier membrane 8 has a larger wall thickness on the side of it which is abutted against the mount plate 2.

In other words, the wall thickness of the barrier membrane 8 is changed so that the contact surface thereof is made flat similarly to the arrangement of a radial tire.

FIG. 2 is a schematic sectional view explaining the hollow member 11. As shown in FIG. 2, the wall thickness of the barrier membrane 8 is formed larger on the lower side of it than on the upper side and both the sides thereof. Furthermore, the wall thicknesses of the boundaries 28 and 29, which are located between both the sides and the lower side, are changed so that they are not deformed when they come into contact with the mount plate 2.

Next, when the silicon wafers 4 are to be polished by means of the polishing apparatus arranged as described above, first, abrasive grain such as an alkaline suspension of colloidal silica, or the like is dispersed on the upper surface of the surface plate 1. Thereafter, the respective components are disposed to the polishing apparatus as shown in FIG. 1.

Next, the silicon wafers 4 are pressed against the upper surface of the surface plate 1 at desired pressure through the mount plate 2 by pressing the press plate 21, which is abutted against the upper surface of the hollow member 11 disposed in the mount head 3 located at the lower portion of the shaft member 20, in the state that the shaft member 20 is fixed.

At the time, the hollow member 11 is arranged such that the wall thickness of the barrier membrane 8 is made larger on the lower side of it than on the upper side thereof. In addition, the wall thicknesses of the boundaries 28 and 29, which are located between both the sides and the lower side, are changed so that they are not deformed when they come into contact with the mount plate 2. Accordingly, the hollow member 11 is deformed similarly to the radial tire and comes into contact with the mount plate 2 at an approximately uniform press force.

Further, a cutout 26 is formed to the press plate 21 by partly cutting out it and an adjustment member 27, which is butted against the upper surface of the hollow member 11, is disposed in the cutout 26. Thus, the swelling state of the hollow member 11 can be adjusted by changing the state in which the adjustment member 27 is pressed against the hollow member 11. The adjustment of the hollow member 11 and the structure of the lower side of the hollow member 11, which is arranged similarly to that of the radial tire, permit the mount plate 2 to be pressed at substantially the same pressure at any portions thereof.

Note, the adjustment member 27 can be displaced by air pressure.

Therefore, the hollow member 11, in which the fluid 10 is sealed, applies an approximately constant press force to the entire surface of the mount plate 2 so that the entire surfaces of the silicon wafers 4 can be pressed at an approximately constant press force.

As described above, the hollow member 11 presses the upper surface of the mount plate 2, whereby the silicon wafers 4, which are fixed to the lower surface of the mount plate 2, are pressed against the upper surface of the surface plate 1. When the surface plate 1 is rotated in this state, the mount plate 2 is rotated in the same direction as that of the surface plate 1 in the same manner in the conventional polishing apparatus to thereby polish the lower surfaces of the silicon wafers 4.

As a result, according to the polishing apparatus of the present invention, since the portion of the mount plate 2 which is in contact with the hollow member 11 receives the approximately uniform press force from the hollow member 11, the polished surfaces of the silicon wafers 4 are not deformed.

That is, since the silicon wafers 4 are approximately uniformly pressed against the upper surface of the surface plate 1, there is not a possibility that the silicon wafers 4 are irregularly polished.

There arises a case that the amount of the fluid 10 in the hollow member 11 is reduced due to aged deterioration and the silicon wafers 4 are not pressed at an optimum press force through the mount plate 2.

In this case, when the second support member 22 is pressed through the first support member 23 by pressurizing the spring member 25, the press plate 21 is lowered by the press force, whereby the hollow member 11 is pressed more than before.

With this operation, the optimum press force can be secured by adjusting the press force.

That is, the respective portions of the hollow member 11, which are in contact with the mount plate 2, can be provided with an approximately uniform press force by the arrangement of the hollow member 11 itself and the adjustment member 27 which partly presses the hollow member 11. Accordingly, the silicon wafers 4 are approximately uniformly pressed to thereby prevent the silicon wafers 4 from being irregularly polished.

Further, since the press force can be also changed while maintaining the silicon wafers in an approximately uniformly pressed state, the press force applied to the silicon wafers can be easily adjusted.

According to the present invention, since the wall thicknesses of the respective portions of the hollow member are changed, the portion of the mount plate, where the hollow member is in contact with it, can be approximately uniformly pressed. The mount plate thereby presses the silicon wafers against the surface plate approximately uniformly so that the silicon wafers can be uniformly polished without irregularity.

At the time, since the portion of the hollow member, which is not in contact with the mount plate, can be pressed by the adjustment member, the lower surface of the hollow member and the portions thereof located on both the sides of the lower surface, in particular, can be adjusted so that they approximately uniformly press the mount plate as well as an optimum pressed state can be obtained. Thus, the silicon wafers can be reliably prevented from being irregularly polished.

Further, since the hollow member can be pressed by the press plate while maintaining the uniformly pressed state of the mount plate, the press force can be easily increased or reduced, whereby there can be obtained an effect that the press force is adjustable.

## Claims

1. A polishing apparatus for polishing the lower surface of a workpiece in the state that a mount plate having the workpiece fixed to the lower surface thereof is pressed against a surface plate located under the mount plate by a mount head disposed above the mount plate, comprising a hollow member disposed in the mount head, said hollow member having a fluid sealed therein and a cross section in which a wall thickness is formed larger on the lower side thereof, wherein said hollow member approximately uniformly presses the mount plate through the portion thereof which is in contact with the mount plate.

2. A polishing apparatus according to claim 1, wherein a press plate for pressing said hollow member and an adjustment member are disposed in the mount head, said adjustment member can be displaced with respect to said press plate, and said hollow member is adjusted by said adjustment member so that the mount plate can be approximately uniformly pressed by the entire surface of said hollow member which is in contact with the mount plate.

3. A polishing apparatus according to claim 2, wherein said adjustment member can be adjusted by air pressure.

4. A polishing apparatus for polishing the lower surface of a workpiece in the state that a mount plate having the workpiece fixed to the lower surface thereof is pressed against a surface plate located under the mount plate by a mount head disposed above the mount plate, comprising:
a hollow member disposed in the mount head, said hollow member having a fluid sealed therein and a cross section in which a wall thickness is formed larger on the lower side thereof;
a press plate and an adjustment member disposed in the mount head, said press plate being abutted against said hollow member; and
a spring member for pressing said press plate,
wherein said hollow member is pressed by said press plate so as to press the mount plate in a prescribed pressed state, said adjustment member is adjusted so that the portion of said hollow member, which is abutted against the mount plate, presses the mount plate approximately uniformly, and the press force is changed by said spring member while the mount plate is uniformly pressed.

5. A polishing apparatus according to claim 4, wherein said adjust member can be adjusted by air pressure.
